# EUROPEAN PATENT APPLICATION

(11) **EP 4 006 967 A1**
(43) Date of publication of application: **01.06.2022**
(21) Application number: 20848270.3
(22) Date of filing: 28.07.2020
(51) Int. Cl.: H01L 23/31, H01L 23/48, H01L 23/49

(54) **PACKAGING DEVICE AND MANUFACTURING METHOD THEREFOR, AND ELECTRONIC DEVICE**

(30) Priority: 30.07.2019 CN 201910696888
(71) Applicant: Huawei Technologies Co., Ltd., Longgang District Shenzhen, Guangdong 518129 (CN)
(72) Inventor: PAN, Weijian, Shenzhen, Guangdong 518129 (CN); HU, Zhixiang, Shenzhen, Guangdong 518129 (CN); YE, Gang, Shenzhen, Guangdong 518129 (CN)
(74) Representative: Gill Jennings & Every LLP
(86) International application number: PCT/CN2020/105303
(87) International publication number: WO 2021/018156

(57) **Abstract**

This application provides a packaging device and a manufacturing method therefor, and an electronic device, and relates to the field of electronic technologies, to resolve a problem that a pin of a packaging device is located on a side surface, and an area of the packaging device is increased as a result, which is not conducive to a lightweight feature of an electronic device. The packaging device includes: a circuit board having a first surface; a first plastic packaging layer covering the first surface, where the first plastic packaging layer includes at least one first channel, the first channel penetrates the first plastic packaging layer in a first direction, and the first direction is a direction perpendicular to the first surface; and at least one first pin, where the first pin is electrically connected to the circuit board, one first pin is located in one first channel, at least a part of the first pin is connected to an inner wall of the first channel, a first conductive surface that is of the first pin and that is away from the circuit board is exposed from the first channel, and the first pin is electrically connected to an external device by using the first conductive surface.

## Description

This application claims priority to Chinese Patent Application No. 201910696888.X, filed with the China National Intellectual Property Administration on July 30, 2019, and entitled "PACKAGING DEVICE AND MANUFACTURING METHOD THEREFOR, AND ELECTRONIC DEVICE", which is incorporated herein by reference in its entirety.

### TECHNICAL FIELD

This application relates to the field of electronic technologies, and in particular, to a packaging device and a manufacturing method therefor, and an electronic device.

### BACKGROUND

With the rapid development of science and technology, communication devices such as mobile phones, computers, tablet computers, and base stations have become popular. To improve product performance and competitiveness, various communication device manufacturers put forward higher requirements on designing, manufacturing, and performance of electronic components such as packaging devices in communication devices.

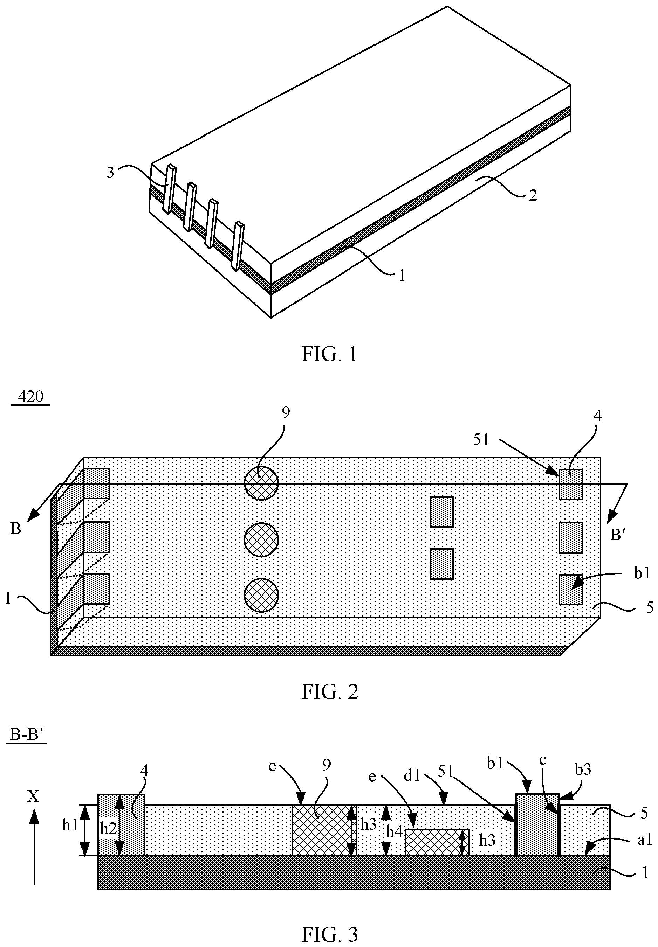

As shown in FIG. 1, a packaging device generally includes a circuit board 1, plastic packaging layers 2 covering an upper surface and a lower surface of the circuit board 1, and a pin (pin) 3 disposed on a side surface of the circuit board 1.

A manufacturing process of the packaging device shown in FIG. 1 is as follows: First, the circuit board 1 is packaged; next, the side surface of the circuit board 1 is cut to expose; and finally, the pin 3 is soldered to the circuit board 1, to obtain the packaging device.

In this way, as shown in FIG. 1, the pin 3 is located on a side surface of the packaging device, the pin 3 does not overlap the plastic packaging layer 2, and the pin 3 needs to occupy separate space. As a result, a length or a width of the packaging device is increased, and an area of the packaging device is increased, which is not conducive to a lightweight feature of an electronic device.

### SUMMARY

Embodiments of this application provide a packaging device and a manufacturing method therefor, and an electronic device, to resolve a problem that a pin of a packaging device is located on a side surface, and an area of the packaging device is increased as a result, which is not conducive to a lightweight feature of an electronic device.

To achieve the foregoing objective, the following technical solutions are used in the embodiments.

According to a first aspect, a packaging device is provided, including: a circuit board having a first surface; a first plastic packaging layer covering the first surface, where the first plastic packaging layer includes at least one first channel, the first channel penetrates the first plastic packaging layer in a first direction, and the first direction is a direction perpendicular to the first surface; and at least one first pin, where the first pin is electrically connected to the circuit board, one first pin is located in one first channel, at least a part of the first pin is connected to an inner wall of the first channel, a first conductive surface that is of the first pin and that is away from the circuit board is exposed from the first channel, and the first pin is electrically connected to an external device by using the first conductive surface. For the packaging device herein, for one thing, the first pin is disposed on the first surface of the circuit board, the first surface is a surface covered with the first plastic packaging layer, and the first pin is located in an area enclosed by the first plastic packaging layer, without occupying separate space. Compared with disposing the first pin on a side surface that intersects the first surface, a dimension (a length or width) of the packaging device in a direction parallel to the first surface can be reduced, thereby reducing an area of the packaging device. In addition, the first pin is disposed on the first surface of the circuit board, so that surface mounted assembly of the packaging device and the external device can be implemented, and different structural requirements can be met. For another thing, at least a part of a side surface of the first pin is connected to the first plastic packaging layer, and the first plastic packaging layer supports the first pin, so that stability of connection between the first pin and the circuit board can be improved, the first pin is prevented from loosening and coming off, and board-level reliability of the first pin is improved. For still another thing, because a surface area of the first surface of the circuit board is larger than a surface area of the side surface of the circuit board that intersects the first surface, compared with disposing the first pin on the side surface of the circuit board that intersects the first surface, process precision and process difficulty of disposing the first pin on the first surface of the circuit board are lower and manufacturing costs can be reduced.

Optionally, the first channel includes a first subchannel and a second subchannel that are connected, and the second subchannel is disposed closer to the circuit board than the first subchannel; there is a gap between a surface of the first pin facing an inner wall of the first subchannel and the inner wall of the first subchannel; and a surface of the first pin facing an inner wall of the second subchannel is connected to the inner wall of the second subchannel. The gap is formed between the surface of the first pin facing the inner wall of the first subchannel and the inner wall of the first subchannel, so that the surface of the first pin facing the inner wall is configured to get covered with solder, thereby increasing an amount of solder on the first pin, and improving stability of electrical connection between the first pin and the external device.

Optionally, the first channel is a through hole, the first channel is located in an area enclosed by side surfaces of the first plastic packaging layer, and the side surfaces of the first plastic packaging layer intersect the first surface. A structure is simple, which is convenient to manufacture.

Optionally, the first channel is a through groove disposed on a side surface of the first plastic packaging layer, and the side surface of the first plastic packaging layer intersects the first surface. When the packaging device in this example is electrically connected to the external device, the solder may cover a second conductive surface of the first pin that is exposed from the first channel, thereby increasing the amount of solder on the first pin, and improving the stability of the electrical connection between the first pin and the external device.

Optionally, the first pin has a second conductive surface flush with a side surface of the circuit board that intersects the first surface, the second conductive surface includes a first conductive subsurface and a second conductive subsurface, and the second conductive subsurface is disposed closer to the circuit board than the first conductive subsurface; and the packaging device further includes a solder mask covering the second conductive subsurface. The solder mask is disposed on the second conductive subsurface of the first pin, so that excessive flow of solder to the second conductive surface can be prevented, thereby ensuring the amount of solder on the first conductive surface of the first pin. In this way, the sufficient amount of solder for connecting the first pin and the external device is ensured, and the stability of the connection between the first pin and the external device is ensured.

Optionally, the packaging device further includes a first conductive protective layer covering the first conductive subsurface. Here, the first conductive protective layer is configured to prevent oxidation of the first conductive subsurface. Therefore, the first conductive protective layer can protect conductive properties of the first conductive subsurface.

Optionally, the packaging device further includes a second conductive protective layer covering the first conductive surface. Here, the second conductive protective layer is configured to prevent oxidation of the first conductive surface. Therefore, the second conductive protective layer can protect conductive properties of the first conductive surface.

Optionally, the first conductive surface is flush with an upper surface that is of the first plastic packaging layer and that is away from the circuit board. It is convenient to manufacture.

Optionally, the packaging device further includes a first electronic component; and the first electronic component is disposed on the first surface, and is electrically connected to the circuit board.

Optionally, an upper surface that is of the first electronic component and that is away from the circuit board is covered by the first plastic packaging layer. It is ensured that the first plastic packaging layer stabilizes the first electronic component.

Optionally, an upper surface that is of the first electronic component and that is away from the circuit board is flush with the upper surface that is of the first plastic packaging layer and that is away from the circuit board. While the first plastic packaging layer stabilizes the first electronic component, a thickness of the first plastic packaging layer is reduced as much as possible, so as to enable a lightweight feature of the packaging device.

Optionally, the circuit board further has a second surface disposed opposite to the first surface; the packaging device further includes a second plastic packaging layer covering the second surface; and the thickness of the first plastic packaging layer is equal to a thickness of the second plastic packaging layer.

According to a second aspect, a manufacturing method for a packaging device is provided, including: soldering at least one first pin in each device area on a first surface of a mother board, where the first pin is electrically connected to the mother board, a plurality of cutting paths intersecting horizontally and vertically are disposed on the mother board, and the plurality of cutting paths intersect to define a plurality of device areas; forming a first plastic packaging layer on the first surface, where a first channel is formed in the first plastic packaging layer at a position corresponding to the first pin, the first channel penetrates the first plastic packaging layer in a first direction, the first direction is a direction perpendicular to the first surface, a first conductive surface that is of the first pin and that is away from the mother board is exposed from the first channel, the first pin is electrically connected to an external device by using the first conductive surface, and at least a part of the first pin is connected to an inner wall of the first channel; and cutting the mother board on which the first plastic packaging layer is formed along the cutting paths to form the packaging device. In a conventional technology, the first pin is soldered after the circuit board is packaged, and thermal shock to the plastic packaging layer is caused by relatively high heat generated in a soldering process. This leads to separation of the plastic packaging layer and the circuit board, or leads to short circuit after remelting of a solder joint between the electronic component and the circuit board, affecting performance of the packaging device. However, according to the manufacturing method for the packaging device provided in this application, before the first plastic packaging layer is formed, the first pin and the first electronic component are soldered on the circuit board, so no thermal shock is caused to the first plastic packaging layer, there is no remelting of the solder joint between the first electronic component and the circuit board, and quality of the packaging device can be ensured. In addition, in this application, the first electronic component and the first pin are soldered on the circuit board at a same stage, without a need to solder the first pin after entering another process following soldering the first electronic component, thereby shortening a manufacturing process of the packaging device.

Optionally, the forming a first plastic packaging layer on the first surface includes: forming a plastic packaging film on the first surface of the mother board, where the plastic packaging film wraps each first pin; and grinding the plastic packaging film to expose the first conductive surface to form the first plastic packaging layer.

Optionally, the forming a first plastic packaging layer on the first surface includes: attaching a barrier film to the first conductive surface of the first pin, where the barrier film is attached to a first conductive surface of each first pin; filling a plastic packaging material between the mother board and the barrier film, where the plastic packaging material wraps a surface that is of each first pin and that intersects the first conductive surface to form a plastic packaging film; and removing the barrier film to expose the first conductive surface to form the first plastic packaging layer.

Optionally, the forming a first plastic packaging layer on the first surface after exposing the first conductive surface further includes: making a groove between the plastic packaging film and the first pin to form a first subchannel having a gap with the first pin and a second subchannel connected to the first pin, where the second subchannel communicates with the first subchannel and is disposed closer to the mother board than the first subchannel.

Optionally, after the cutting the mother board on which the first plastic packaging layer is formed, the manufacturing method for the packaging device further includes: grinding a cutting surface to expose a surface that is of the first pin, that intersects the first conductive surface, and that is closest to the cutting surface.

According to a third aspect, an electronic device is provided, including the packaging device according to any implementation of the first aspect.

### BRIEF DESCRIPTION OF DRAWINGS

FIG. 1 is a schematic diagram of a structure of a packaging device according to a conventional technology;
FIG. 2 is a schematic diagram of a structure of a packaging device according to an embodiment of this application;
FIG. 3 is a sectional view taken along a direction B-B' in FIG. 2;
FIG. 4 is a schematic diagram of a structure of electrical connection between a packaging device and an external device according to an embodiment of this application;
FIG. 5 is a schematic diagram of a structure of a first plastic packaging layer according to an embodiment of this application;
FIG. 6 is a sectional view taken along a direction O-O' in FIG. 5;
FIG. 7a is a schematic diagram of a structure of another type of electrical connection between a packaging device and an external device according to an embodiment of this application;
FIG. 7b is a schematic diagram of a structure of still another type of electrical connection between a packaging device and an external device according to an embodiment of this application;
FIG. 8a is a schematic top view of a first plastic packaging layer according to an embodiment of this application;
FIG. 8b is a sectional view taken along a direction D-D' in FIG. 8a;
FIG. 9a is a schematic top view of a packaging device according to an embodiment of this application;
FIG. 9b is a sectional view taken along a direction E-E' in FIG. 9a;
FIG. 9c is a schematic diagram of a structure of still another type of electrical connection between a packaging device and an external device according to an embodiment of this application;
FIG. 10 is a schematic diagram of a structure of still another type of electrical connection between a packaging device and an external device according to an embodiment of this application;
FIG. 11a is a schematic diagram of a structure of another first plastic packaging layer according to an embodiment of this application;
FIG. 11b is a schematic side view of a first plastic packaging layer according to an embodiment of this application;
FIG. 12a is a schematic diagram of a structure of still another first plastic packaging layer according to an embodiment of this application;
FIG. 12b is a schematic side view of a first plastic packaging layer according to an embodiment of this application;
FIG. 13a is a schematic diagram of a structure of a packaging device according to an embodiment of this application;
FIG. 13b is a schematic diagram of a structure of still another type of electrical connection between a packaging device and an external device according to an embodiment of this application;
FIG. 14 is a schematic side view of a packaging device according to an embodiment of this application;
FIG. 15 is a schematic side view of another packaging device according to an embodiment of this application;
FIG. 16 is a schematic side view of still another packaging device according to an embodiment of this application;
FIG. 17 is a schematic side view of still another packaging device according to an embodiment of this application;
FIG. 18 is a schematic side view of still another packaging device according to an embodiment of this application;
FIG. 19 is a schematic side view of still another packaging device according to an embodiment of this application;
FIG. 20 is a flowchart of a manufacturing method for a packaging device according to an embodiment of this application;
FIG. 21 to FIG. 28 are schematic diagrams of manufacturing processes of a packaging device according to an embodiment of this application; and
FIG. 29 is a flowchart of another manufacturing method for a packaging device according to an embodiment of this application.

### Reference numerals:

410: External device; 420: Packaging device; 430: Solder; 1: Circuit board; 2: Plastic packaging layer; 3: Pin; 4: First pin; 5: First plastic packaging layer; 51: First channel; 511: First subchannel; 512: Second subchannel; 52: Plastic packaging film; 53: Barrier film; 6: Solder mask; 7: First conductive protective layer; 71: Nickel film layer; 72: Gold film layer; 8: Second conductive protective layer; 9: First electronic component; 10: Second plastic packaging layer; 101: Second channel; 11: Second pin; 12: Second electronic component; 13: Mother board; 131: Device area; 132: Cutting path.

### DESCRIPTION OF EMBODIMENTS

Unless otherwise defined, technical terms or scientific terms used in this application shall have ordinary meanings understood by a person skilled in the art. Terms "first", "second", "third" and similar expressions used in the specification and claims of this application are not intended to indicate any order, quantity, or importance, but are merely used to distinguish between different components. Thus, a feature defined by "first", "second", or "third" may explicitly or implicitly include one or more of the feature. In the description of the embodiments of this application, unless otherwise stated, "a plurality of' means two or more than two.

Orientation terms such as "left", "right", "up", and "down" are defined with respect to an orientation in which a device is schematically placed in a drawing. It should be understood that these directional terms are relative concepts and are used for relative description and clarification, which can be changed accordingly based on a change of an orientation in which a liquid crystal display device is placed.

An embodiment of this application provides a packaging device 420. As shown in FIG. 2, the packaging device 420 includes: a circuit board 1, at least one first pin 4, a first electronic component 9, and a first plastic packaging layer 5.

The circuit board 1 may be a printed circuit board (printed circuit board, PCB).

On this basis, the circuit board 1 may be one of a single-sided board or a double-sided board. The single-sided board has only one surface for electrical connection with other devices, and the double-sided board has a set of opposite surfaces for electrical connection with other devices. The circuit board 1 may be a single-layer circuit board having one re-distribution layer, or may be a multi-layer circuit board having a plurality of re-distribution layers. The re-distribution layer includes a conductive layer and an insulation layer that are stacked.

As shown in FIG. 3 (a sectional view taken along a direction B-B' in FIG. 2), the circuit board 1 has a first surface a1. The first plastic packaging layer 5, the at least one first pin 4, and the first electronic component 9 are all disposed on the first surface a1.

Both the first pin 4 and the first electronic component 9 are electrically connected to the circuit board 1, and the first plastic packaging layer 5 covers the first surface a1. It may be understood that, when the circuit board 1 is a single-sided board, because only one surface of the circuit board 1 may be electrically connected to another device, the surface on which the circuit board 1 may be electrically connected to another device is the first surface a1.

The first electronic component 9 may be an active electronic component (active component), for example, a transistor, a silicon controlled rectifier, a diode, or a valve. The first electronic component 9 may alternatively be a passive electronic component (passive component), for example, a resistor, a capacitor, or an inductor.

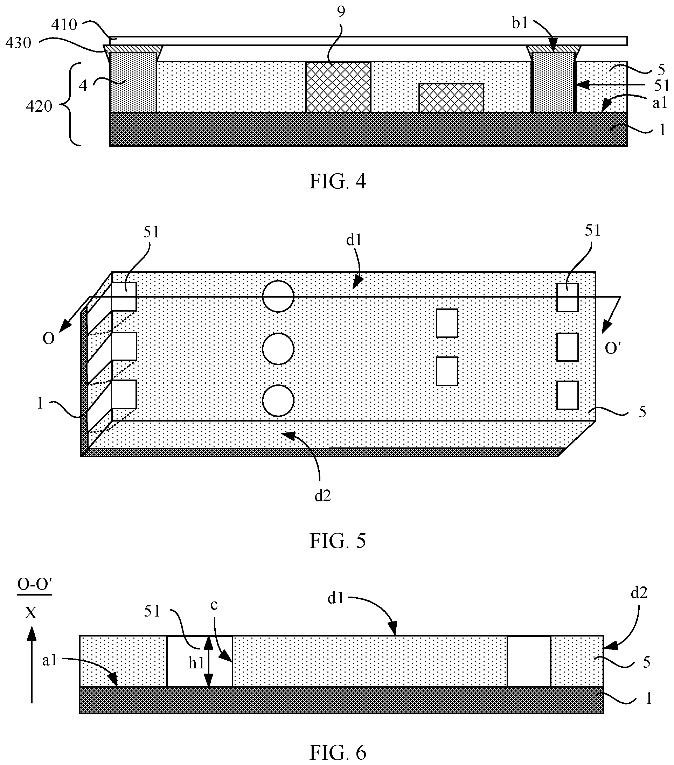

As shown in FIG. 4, a conductive surface that is of the first pin 4 and that is close to the circuit board 1 is electrically connected to the circuit board 1, and a first conductive surface b1 that is of the first pin 4 and that is away from the circuit board 1 is exposed outside the first plastic packaging layer 5 and is used for electrical connection with an external device 410 to achieve electrical connection between the packaging device 420 and the external device 410. For example, the first conductive surface b1 may be electrically connected to the external device 410 by using solder 430.

The external device 410 herein may be, for example, an electronic component, a chip, or a circuit structure other than the packaging device 420.

The first pin 4 may be of any shape. The first pin 4 may be, for example, cylindrical or quadrangular. A material of the first pin 4 is a conductive material, for example, may be metal. In an example, the material of the first pin 4 is copper.

Based on this, as shown in FIG. 5, the first plastic packaging layer 5 includes at least one first channel 51. In FIG. 5, an example in which the first plastic packaging layer 5 includes a plurality of first channels 51 is used for illustration.

As shown in FIG. 6 (a sectional view taken along a direction O-O' in FIG. 5), the first channel 51 penetrates the first plastic packaging layer 5 in a first direction X, and the first direction X is a direction perpendicular to the first surface a1. In this case, a dimension h1 of each first channel 51 in the first direction X is equal to a dimension of the first plastic packaging layer 5 in the first direction X.

It should be understood that "perpendicular" described in this application may alternatively be not absolute vertical. That the first direction X is perpendicular to the first surface a1 may be that an included angle range between the first direction X and the first surface a1 is [90-θ, 90+θ]°, which may include a specific engineering error and is not necessarily strictly 90°.

A material of the first plastic packaging layer 5 is an insulating material, for example, green oil, polybenzoxazole (polybenzoxazole, PBO), or polyimide (polyimide, PI).

As shown in FIG. 3, one first pin 4 is located in one first channel 51, and the first conductive surface b1 that is of the first pin 4 and that is away from the circuit board 1 is exposed from the first channel 51.

In other words, the first channel 51 is configured to accommodate the first pin 4, but the first channel 51 does not affect the electrical connection of the first pin 4 to the external device 410 by using the first conductive surface b1, or the electrical connection of the first pin 4 to the circuit board 1 by using another conductive surface opposite to the first conductive surface b1.

To enable the first plastic packaging layer 5 to stabilize the first pin 4, in some embodiments, as shown in FIG. 3, at least a part of the first pin 4 is connected to an inner wall c of the first channel 51.

It may be understood that, the first pin 4 is located in the first channel 51, so a surface on which the first pin 4 is connected to the inner wall c of the first channel 51 may be a side surface b3 that is of the first pin 4 and that intersects the first conductive surface b1. The first conductive surface b1 and the surface opposite to the first conductive surface b1 that are of the first pin 4 may neither be connected to the inner wall of the first channel 51.

The side surface b3 of the first pin may be disposed around a contour of the first conductive surface b1.

On this basis, as shown in FIG. 3, at least a part of the side surface b3 of the first pin 4 is connected to the inner wall c of the first channel 51.

The connection herein may be that the inner wall c of the first channel 51 is indirectly connected to the first pin 4, or may be that the inner wall c of the first channel 51 is directly connected to the first pin 4.

For example, in a manufacturing process, the first pin 4 and the first electronic component 9 may be separately soldered on the first surface a1 of the circuit board 1 before the first plastic packaging layer 5 is formed.

In this case, the first plastic packaging layer 5 may wrap the side surface b3 of the first pin 4 to achieve connection. In addition, as shown in FIG. 3, the first plastic packaging layer 5 may cover the first electronic component 9, or the first plastic packaging layer 5 may expose the first electronic component 9.

For the packaging device 420 provided in this embodiment of this application, for one thing, the first pin 4 is disposed on the first surface a1 of the circuit board 1, the first surface a1 is a surface covered with the first plastic packaging layer 5, and the first pin 4 is located in an area enclosed by the first plastic packaging layer 5, without occupying separate space. Compared with disposing the first pin 4 on a side surface that intersects the first surface a1, a dimension (a length or width) of the packaging device 420 in a direction parallel to the first surface a1 can be reduced, thereby reducing an area of the packaging device 100.

In addition, the first pin 4 is disposed on the first surface a1 of the circuit board 1, so that surface mounted assembly of the packaging device 420 and the external device can be implemented, and different structural requirements can be met.

For another thing, the at least a part of the side surface b3 of the first pin 4 is connected to the first plastic packaging layer 5, and the first plastic packaging layer 5 supports the first pin 4, so that stability of the connection between the first pin 4 and the circuit board 1 can be improved, the first pin 4 is prevented from loosening and coming off, and board-level reliability of the first pin 4 and the circuit board 1 is improved.

For still another thing, because a surface area of the first surface a1 of the circuit board 1 is larger than a surface area of the side surface of the circuit board 1 that intersects the first surface a1, compared with disposing the first pin 4 on the side surface of the circuit board 1 that intersects the first surface a1, process precision and process difficulty of disposing the first pin 4 on the first surface a1 of the circuit board 1 are lower and manufacturing costs can be reduced.

The following describes a structure of the packaging device 420 provided in this embodiment of this application by using several examples.

### Example 1

As shown in FIG. 3, the packaging device 420 includes the circuit board 1, the first pin 4, the first electronic component 9, and the first plastic packaging layer 5.

The circuit board 1 has the first surface a1.

The first plastic packaging layer 5 covers the first surface a1, the first plastic packaging layer 5 includes at least one first channel 51, and the first channel 51 penetrates the first plastic packaging layer 5 in the first direction X.

The first channel 51 is a through hole, and the first channel 51 is located in an area enclosed by side surfaces d2 of the first plastic packaging layer 5.

It may be understood that the first channel 51 herein is a through hole relative to the first plastic packaging layer 5; in other words, the first channel 51 penetrates the first plastic packaging layer 5. However, for the entire packaging device, the first channel 51 is a blind hole, and the first channel 51 does not penetrate the circuit board 1. The side surfaces d2 of the first plastic packaging layer 5 intersect both an upper surface d1 that is of the first plastic packaging layer 5 and that is away from the circuit board 1 and the first surface a1.

One first pin 4 is located in one first channel 5, and at least a part of the first pin 4 is connected to the inner wall c of the first channel 51. The first pin 4 is electrically connected to the circuit board 1.

The first conductive surface b1 that is of the first pin 4 and that is away from the circuit board 1 is exposed from the first channel 51. The first direction X is the direction perpendicular to the first surface a1.

The first pin 4 is located in the first channel 51, and a connection relationship between the first pin 4 and the first channel 51 may include two cases.

In the first case, as shown in FIG. 3, the first channel 51 wraps only a part of the side surface b3 of the first pin 4, and the side surface b3 of the first pin 4 is not fully connected to the inner wall c of the first channel 51.

In some embodiments, as shown in FIG. 3, the dimension h1 of the first channel 51 in the first direction X is smaller than a dimension h2 (or referred to as a thickness of the first pin 4) of the first pin 4 in the first direction X. That is, the first conductive surface b1 of the first pin 4 is higher than the upper surface d1 of the first plastic packaging layer 5 in the first direction X.

In this case, as shown in FIG. 4, the first pin 4 extends out of the first channel 51. In a process of soldering between the first pin 4 and the external device 410, a part of the side surface b3 of the first pin 4 that is not connected to the inner wall c of the first channel 51 may be covered with the solder 430, thereby increasing an amount of coverage of the solder 430 on the side that is of the first pin 4 and that is close to the external device 410. Because the first pin 4 is electrically connected to the external device 410 by using the solder 430, the increasing of the solder 430 between the first pin 4 and the external device 410 may increase stability of the electrical connection between the first pin 4 and the external device 410.

In the second case, the first channel 51 wraps the side surface b3 of the first pin 4, and the side surface b3 of the first pin 4 is fully connected to the inner wall c of the first channel 51.

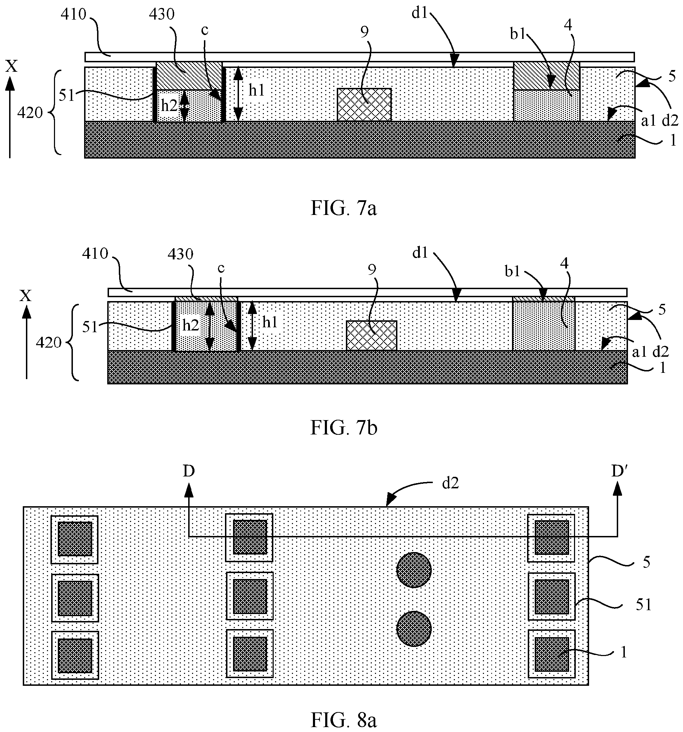

In some embodiments, as shown in FIG. 7a, the dimension h1 of the first channel 51 in the first direction X is larger than a dimension h2 of the first pin 4 in the first direction X. That is, the first conductive surface b1 of the first pin 4 is lower than the upper surface d1 of the first plastic packaging layer 5 in the first direction X.

In this case, the first channel 51 is not fully filled by the first pin 4. When the first pin 4 is electrically connected to the external device 410, the solder 430 can be filled into the first channel 51 to increase the amount of solder between the first pin 4 and the external device 410, thereby increasing stability of the electrical connection between the first pin 4 and the external device 410.

In some embodiments, as shown in FIG. 7b, the dimension h1 of the first channel 51 in the first direction X is equal to the dimension h2 of the first pin 4 in the first direction X. That is, the upper surface d1 of the first plastic packaging layer 5 is flush with the first conductive surface b1 of the first pin 4.

For a manufacturing method for the packaging device 420 shown in FIG. 7b, in some embodiments, the first plastic packaging layer 5 is processed by using a grinding process.

For example, a plastic packaging film is formed on the first surface a1 of the circuit board 1, where the plastic packaging film wraps each first pin 4.

Here, the plastic packaging film wraps a first conductive surface b1 and a side surface b3 of each pin.

The plastic packaging film is ground to expose the first conductive surface b1 to form the packaging device 420 shown in FIG. 7b.

In some other embodiments, the first plastic packaging layer 5 may be formed by using a tape molding (tape molding) process.

For example, in a manufacturing process, a barrier film is first attached to the first conductive surface b1 of the first pin 4, where the barrier film is attached to a first conductive surface b1 of each first pin 4.

The barrier film is attached to the first conductive surface b1 of each first pin 4, so that it can be ensured that after the barrier film is removed in a subsequent manufacturing process, the first conductive surface b1 of each first pin 4 can be exposed, so as to ensure the complete electrical connection.

A plastic packaging material is filled between the circuit board 1 and the barrier film, where the plastic packaging material wraps the side surface b3 of each first pin 4 to form the first plastic packaging layer 5.

The barrier film is removed to expose the first conductive surface b1.

For a dimensional relationship between the first plastic packaging layer 5 and the first electronic component 9, to enable the first plastic packaging layer 5 to protect and stabilize the first electronic component 9, in some embodiments, as shown in FIG. 3, an upper surface e that is of the first electronic component 9 and that is away from the circuit board 1 is covered by the first plastic packaging layer 5.

In other words, a dimension h3 (or referred to as a thickness of the first electronic component 9) of the first electronic component 9 in the first direction X is smaller than a dimension h4 (or referred to as a thickness of the first plastic packaging layer 5) of the first plastic packaging layer 5 in the first direction X. The dimension h4 of the first plastic packaging layer 5 in the first direction X is equal to the dimension h1 of the first channel 51 in the first direction X.

It is equivalent to that a groove is disposed on a surface that is of the first plastic packaging layer 5 and that is close to the circuit board 1, and the groove is configured to accommodate the first electronic component 9.

When the dimension h3 of the first electronic component 9 in the first direction X is excessive large, the dimension h4 of the first plastic packaging layer 5 in the first direction X is also large, which results in a large dimension of the packaging device 420 in the first direction X, and is not conducive to a lightweight feature of the packaging device 420.

In some embodiments, as shown in FIG. 3, the upper surface e that is of the first electronic component 9 and that is away from the circuit board 1 is flush with the upper surface d1 that is of the first plastic packaging layer 5 and that is away from the circuit board 1.

In other words, the dimension h3 of the first electronic component 9 in the first direction X is equal to the dimension h4 of the first plastic packaging layer 5 in the first direction X.

It may be understood that, as shown in FIG. 3, the upper surface e of the first electronic component 9 is flush with the upper surface d1 of the first plastic packaging layer 5, so the first plastic packaging layer 5 may expose the upper surface e of the first electronic component 9. Based on this, like the first pin 4, the first electronic component 9 is independently disposed in a channel similar to the first channel 51 on the first plastic packaging layer 5.

To improve stabilization of the first electronic component 9 in the first channel 51, in some embodiments, as shown in FIG. 3, the first electronic component 9 is connected to an inner wall of the first channel 51.

Because the first electronic component 9 is also provided with a packaging layer, even though the first plastic packaging layer 5 exposes the upper surface e of the first electronic component 9, performance of the first electronic component 9 is not affected.

It should be noted that, as shown in FIG. 3, when the packaging device 420 includes a plurality of first electronic components 9 having unequal dimensions in the first direction X, the first plastic packaging layer 5 may expose an upper surface e of a first electronic component 9 having a largest dimension in the first direction X among the plurality of first electronic components 9, and all upper surfaces e of the remaining first electronic components 9 are covered by the first plastic packaging layer 5.

In this example, the side surface b3 of the first pin 4 is fully connected to the inner wall c of the first channel 51, and the first plastic packaging layer 5 provides support for the first pin 4, thereby avoiding shaking of the first pin 4, and improving stability of the connection between the first pin 4 and the circuit board 1.

### Example 2

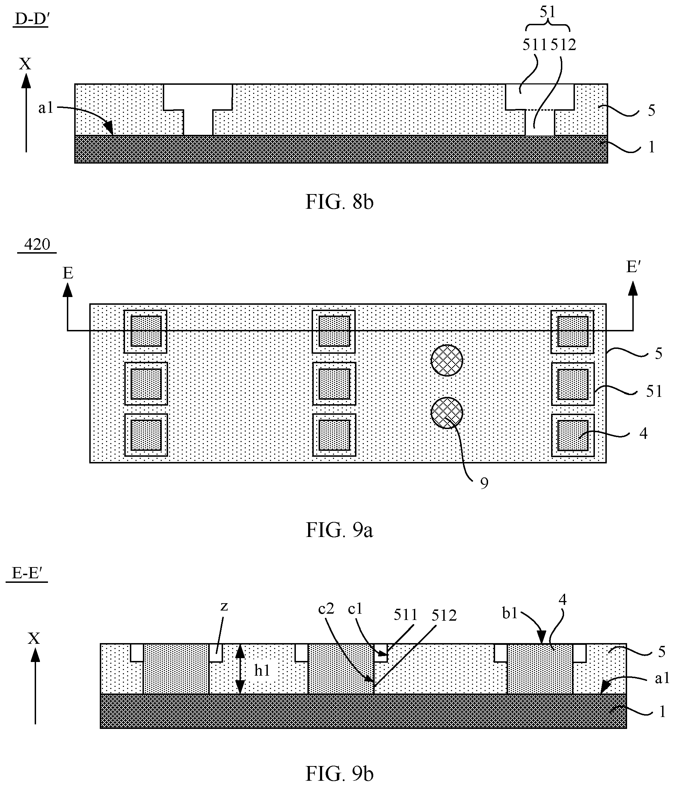

As shown in FIG. 8a and FIG. 8b (a sectional view taken along a direction D-D' in FIG. 8a), Example 2 differs from Example 1 in that the first channel 51 configured to place the first pin 4 includes a first subchannel 511 and a second subchannel 512 that are connected, and the second subchannel 512 is disposed closer to the circuit board 1 than the first subchannel 511.

As shown in FIG. 9a, the first pin 4 and the first electronic component 9 are separately disposed in one first channel 51.

As shown in FIG. 9b (a sectional view taken along a direction E-E' in FIG. 9a), there is a gap z between a surface of the first pin 4 facing an inner wall c1 of the first subchannel 511 and the inner wall c1 of the first subchannel 511.

In some embodiments, the gap z may be formed on the basis of the first plastic packaging layer 5 in Example 1 through laser grooving.

A dimension of the gap z in a first direction X may be smaller than the dimension h1 of the first channel 51 in the first direction X.

As shown in FIG. 9b, a surface of the first pin 4 facing an inner wall c2 of the second subchannel 512 is connected to the inner wall c2 of the second subchannel 512.

To be specific, the first subchannel 511 is a through hole, the second subchannel 512 is also a through hole, and an aperture of the second subchannel 512 is smaller than an aperture of the first subchannel 511.

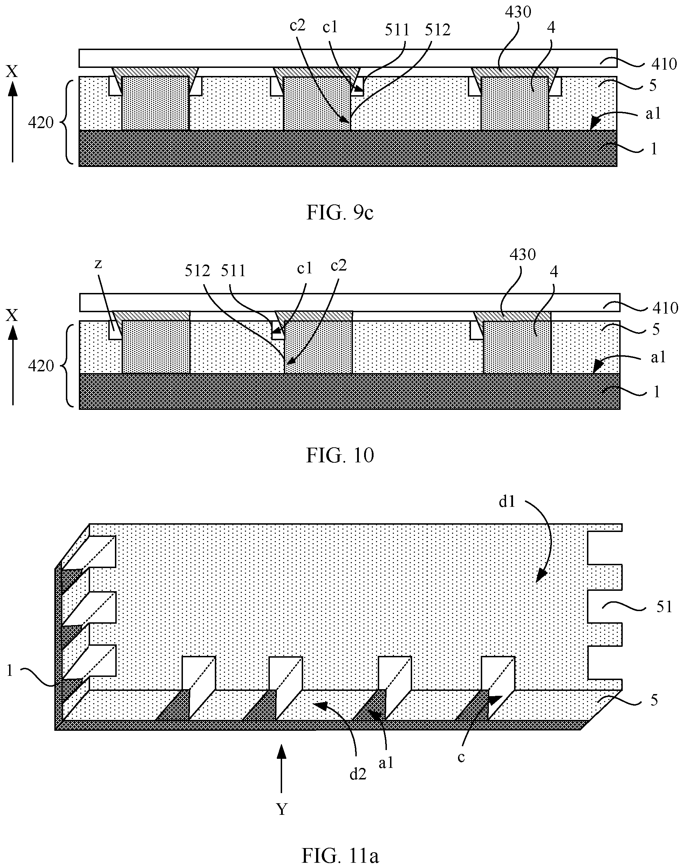

In this way, as shown in FIG. 9c, the inner wall c2 of the second subchannel 512 can stabilize the connection between the first pin 4 and the circuit board 1. The gap z between the inner wall c 1 of the first subchannel 511 and the first pin 4 may enable the surface of the first pin 4 facing the inner wall c1 to get covered with the solder 430, thereby increasing the amount of the solder 430 on the first pin 4, and improving the stability of the electrical connection between the first pin 4 and the external device 410.

In some embodiments, as shown in FIG. 10, the gap z is not disposed in a circle around the first pin 4, but is disposed at a partial location around a periphery of the first pin 4.

In this example, the gap z is formed between the surface of the first pin 4 facing the inner wall c1 of the first subchannel 511 and the inner wall c1 of the first subchannel 511, so that the surface of the first pin 4 facing the inner wall c1 is configured to get covered with the solder 430, thereby increasing the amount of the solder 430 on the first pin 4, and improving the stability of the electrical connection between the first pin 4 and the external device 410.

### Example 3

As shown in FIG. 11a, Example 3 differs from Example 1 and Example 2 in that the first channel 51 is a through groove, and the first channel 51 is located on the side surface d2 of the first plastic packaging layer 5.

In this case, a groove wall c of the through groove serves as a part of the side surface d2 of the first plastic packaging layer 5.

The side surface d2 of the first plastic packaging layer 5 intersects both the first surface a1 and the upper surface d1 that is of the first plastic packaging layer 5 and that is away from the circuit board 1.

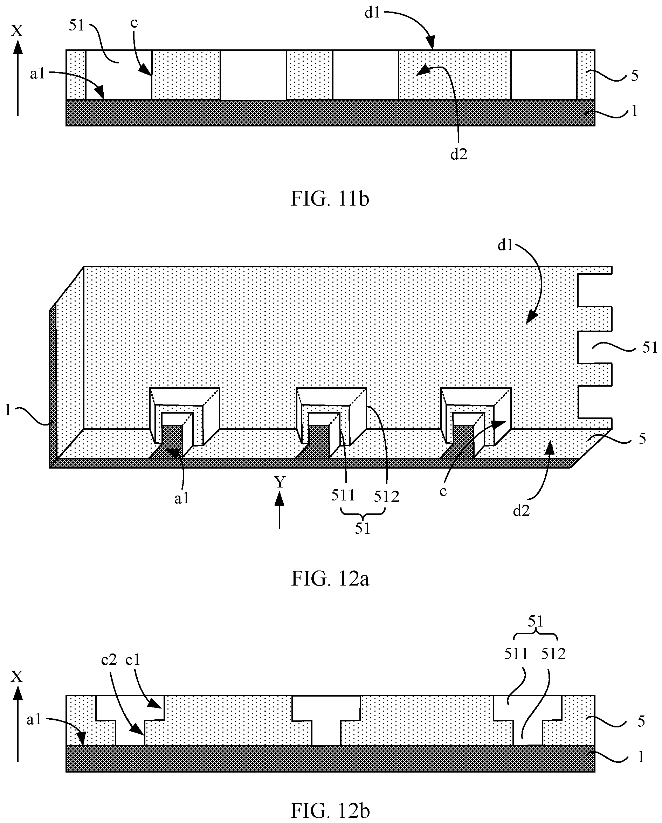

In some embodiments, as shown in FIG. 11a, a cross-sectional area of the through groove is unchanged in the first direction X. As shown in FIG. 11b (a view taken along a Y direction in FIG. 11a), projection of groove walls of the through groove in the first direction X is two parallel lines.

In some embodiments, as shown in FIG. 12a, the first channel 51 configured to place the first pin 4 includes the first subchannel 511 and the second subchannel 512 that are connected, and the second subchannel 512 is disposed closer to the circuit board 1 than the first subchannel 511. A cross-sectional area of the first subchannel 511 is larger than a cross-sectional area of the second subchannel 512.

As shown in FIG. 12b (a view taken along a Y direction in FIG. 12a), projection of groove walls of the through groove in the first direction X is in a stepped shape. The first subchannel 511 is a through groove, the second subchannel 512 is also a through groove, and the first channel 51 having a through groove structure is a stepped groove.

For a location relationship between the first channel 51 and the first pin 4, refer to related descriptions in Example 1 and Example 2.

For formation of the first channel 51 having a through groove structure, for example, after the structure shown in FIG. 8a is formed, the side surface d2 of the first plastic packaging layer 5 may be ground to form the through groove.

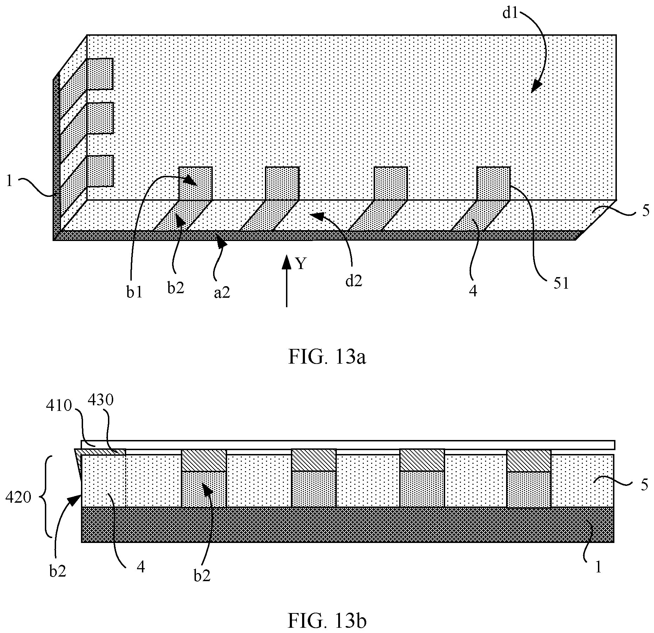

Based on the structure of the first channel 51 provided in this example, as shown in FIG. 13a, because the first channel 51 is the through groove having an opening, after the first pin 4 is placed in the first channel 51, the opening of the through groove exposes a part of a side surface b3 of the first pin 4. This side surface is referred to as a second conductive surface b2, and the second conductive surface b2 is flush with a side surface a2 of the circuit board 1 that intersects the first surface a1.

As shown in FIG. 13b (a view taken along a Y direction in FIG. 13a), when the packaging device 420 in this example is electrically connected to the external device 410, the solder 430 may cover the second conductive surface b2 of the first pin 4, thereby increasing the amount of the solder 430 on the first pin 4, and improving the stability of the electrical connection between the first pin 4 and the external device 410.

### Example 4

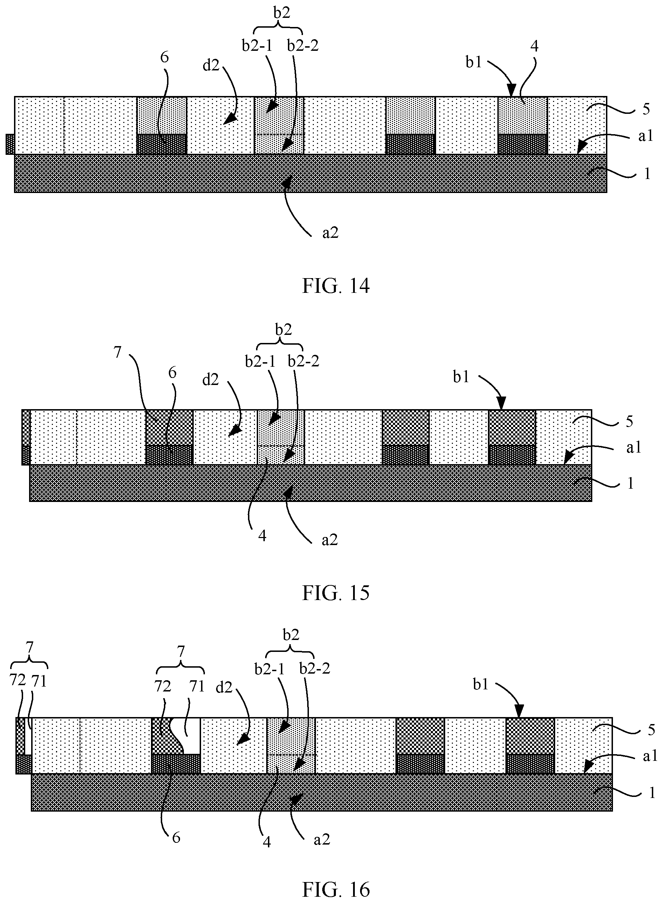

As shown in FIG. 14 (a view taken along a Y direction in FIG. 13a), Example 4 differs from Example 3 in that the second conductive surface b2 includes a first conductive subsurface b2-1 and a second conductive subsurface b2-2, and the second conductive subsurface b2-2 is disposed closer to the circuit board 1 than the first conductive subsurface b2-1.

The packaging device 420 further includes a solder mask 6 covering the second conductive subsurface b2-2.

The solder mask 6 is characterized in that it is not solderable, and soldering fluid is difficult to flow on the solder mask 6. In this way, during soldering, the solder mask 6 can prevent the soldering fluid from flowing along the second conductive surface b2 of the first pin 4 toward a side on which the circuit board 1 is located.

A material of the solder mask 6 may be an insulating material, or an oxidized material generated after surface treatment is performed on the first pin 4. In this case, an oxide film is used as the solder mask 6 herein.

Because solder flows along the second conductive surface b2 of the first pin 4 toward the side on which the circuit board 1 is located in a soldering process, it is likely to lead to a decrease or even a lack of the solder on the first conductive surface b1 of the first pin 4, further affecting the stability of the connection between the first pin 4 and the external device.

Therefore, the solder mask 6 is disposed on the second conductive subsurface b2-2 of the first pin 4, so that excessive flow of the solder 430 to the second conductive surface b2 can be prevented, thereby ensuring the amount of the solder on the first conductive surface b 1 of the first pin 4. In this way, the sufficient amount of the solder for connecting the first pin 4 and the external device 410 is ensured, and the stability of the connection between the first pin 4 and the external device 410 is ensured.

On this basis, to avoid oxidation of the first conductive subsurface b2-1, in some embodiments, as shown in FIG. 15, the packaging device 420 further includes a first conductive protective layer 7 covering the first conductive subsurface b2-1. The first conductive protective layer 7 herein is configured to prevent the oxidation of the first conductive subsurface b2-1, to ensure conductive properties of the first conductive subsurface b2-1.

In some embodiments, the first conductive protective layer 7 may be formed, for example, by dipping tin liquid.

In this case, as shown in FIG. 15, the first conductive protective layer 7 is a tin metal layer.

To improve accuracy of the first conductive protective layer 7, and avoid a conductive material on other parts, in some embodiments, the first conductive protective layer 7 may alternatively be formed by using a chemical plating process.

For example, a nickel film layer may be first plated, and then a gold film layer may be plated.

In this case, as shown in FIG. 16, the first conductive protective layer 7 includes a nickel film layer 71 and a gold film layer 72 that are stacked, and the nickel film layer 71 is disposed closer to the second conductive surface b2 of the first pin 4 than the gold film layer 72.

The first conductive protective layer 7 is disposed on the first conductive subsurface b2-1, so that a problem that the conductive properties of the first pin 4 are affected because the first conductive subsurface b2-1 is oxidized into an insulating material can be avoided.

### Example 5

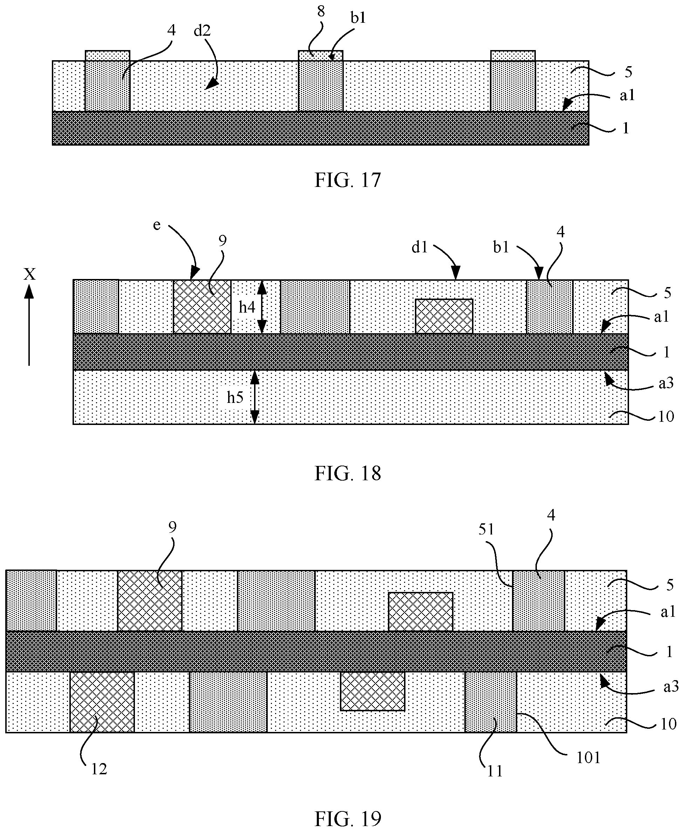

Example 5 differs from Example 1 to Example 4 in that, as shown in FIG. 17, on the basis of the structure of Example 1 to Example 4, the packaging device 420 further includes a second conductive protective layer 8 covering the first conductive surface b1. The second conductive protective layer 8 herein is configured to prevent oxidation of the first conductive surface b1, to ensure conductive properties of the first conductive surface b1.

A material and a manufacturing process of the second conductive protective layer 8 may be the same as those of the first conductive protective layer 7.

The second conductive protective layer 8 is disposed on the first conductive surface b1, so that a problem that the electrical connection between the packaging device 420 and the external device 410 is affected due to a fact that the conductive properties of the first pin 4 are affected because the first conductive surface b1 is oxidized into an insulating material can be avoided.

### Example 6

Example 6 differs from Example 1 to Example 5 in that:
As shown in FIG. 18, the circuit board 1 further includes a second surface a3 disposed opposite to the first surface a1.

The packaging device 420 further includes a second plastic packaging layer 10 covering the second surface a3.

In some embodiments, the thickness h4 (or referred to as the dimension of the first plastic packaging layer 5 in the first direction X) of the first plastic packaging layer 5 is equal to a thickness h5 (or referred to as a dimension of the second plastic packaging layer 10 in the first direction X) of the second plastic packaging layer 10.

A material of the second plastic packaging layer 10 may be the same as that of the first plastic packaging layer 5.

In a high temperature environment, both the first plastic packaging layer 5 and the second plastic packaging layer 10 are deformed by heat, applying a traction force to the circuit board 1. Therefore, by setting the dimension h4 of the first plastic packaging layer 5 in the first direction X to be the same as the dimension h5 of the second plastic packaging layer 10 in the first direction X, a difference in traction forces applied to the circuit board 1 by the first plastic packaging layer 5 and the second plastic packaging layer 10 can be reduced, and deformation of the circuit board 1 is avoided, so as to ensure stability of electrical connection between the circuit board 1 and the first pin 4 and the first electronic component 9, and reliability of the packaging device 420.

In some embodiments, as shown in FIG. 19, the second plastic packaging layer 10 further includes a second channel 101, and the second channel 101 penetrates the second plastic packaging layer 10 in the first direction X.

For a structure, a disposing position, and a function of the second channel 101, refer to the foregoing description of the first channel 51. Details are not described herein again.

The packaging device 420 further includes at least one second pin 11, and the second pin 11 is electrically connected to the circuit board 1.

One second pin 11 is located in one second channel 101, a third conductive surface f1 that is of the second pin 11 and that is away from the circuit board 1 is exposed from the second channel 101, and at least a part of the second pin 11 is connected to an inner wall of the second channel 101.

For a structure of the second pin 11 and a structural relationship between the second pin 11 and the second channel 101, refer to the description of the structural relationship between the first pin 4 and the first channel 51 in Example 1 to Example 3.

In some embodiments, as shown in FIG. 19, the packaging device 420 further includes a second electronic component 12, and the second electronic component 12 is disposed on the second surface a2 of the circuit board 1 and is electrically connected to the circuit board 1.

For example, the second electronic component 12 and the circuit board 1 may be soldered together when the second pin 11 is soldered to the circuit board 1.

For a structural relationship between the second electronic component 12 and the second plastic packaging layer 10, refer to the foregoing description of the structural relationship between the first electronic component 9 and the first plastic packaging layer 5.

In other words, pins and electronic components may be disposed on both the first surface a1 and the second surface a3 of the circuit board 1, and disposing manners of the pins and the electronic components on the first surface a1 and the second surface a3 may be the same.

Structures of the plurality of first channels 51 and a plurality of second channels 101 may not be entirely the same.

According to the foregoing description, it may be understood that one packaging device 420 may include solutions shown in the foregoing several examples at the same time, and any combination of features shown in the foregoing examples still falls within the protection scope of the embodiments of this application.

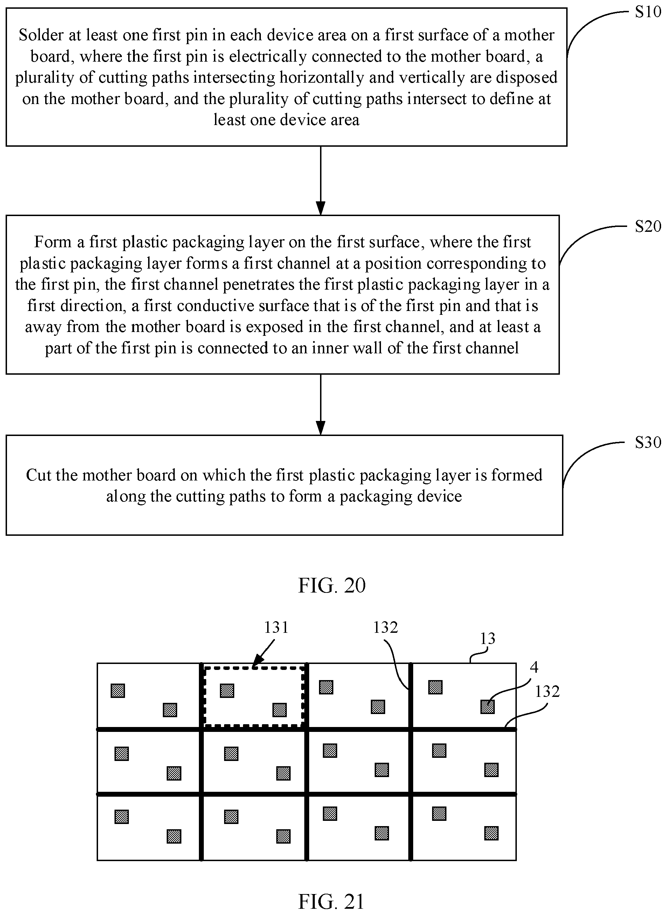

An embodiment of this application further provides a manufacturing method for a packaging device. As shown in FIG. 20, the manufacturing method for the packaging device includes the following steps.

S10: As shown in FIG. 21, solder at least one first pin 4 in each device area 131 on a first surface of a mother board 13, where the first pin 4 is electrically connected to the mother board 13.

A plurality of cutting paths 132 intersecting horizontally and vertically are disposed on the mother board 13, the plurality of cutting paths 132 intersect to define at least one device area 131, and one device area 131 corresponds to one packaging device 420. A part of the mother board 13 located in each device area 131 serves as a circuit board 1 in one packaging device 420, and a first pin 4 located in the device area 131 serves as a first pin 4 of one packaging device 420.

In some embodiments, the packaging device further includes a first electronic component 9, and at least one first electronic component 9 is soldered in each device area 131 on the first surface of the mother board 13.

In some embodiments, a second pin 11 and a second electronic component 12 are disposed on a second surface that is of the mother board 13 and that is opposite to the first surface.

After the soldering of the first surface is completed, at least one second pin 11 and at least one second electronic component 12 are soldered in each device area 131 on the second surface of the mother board 13.

Here, a soldering manner may be, for example, reflow soldering or laser soldering.

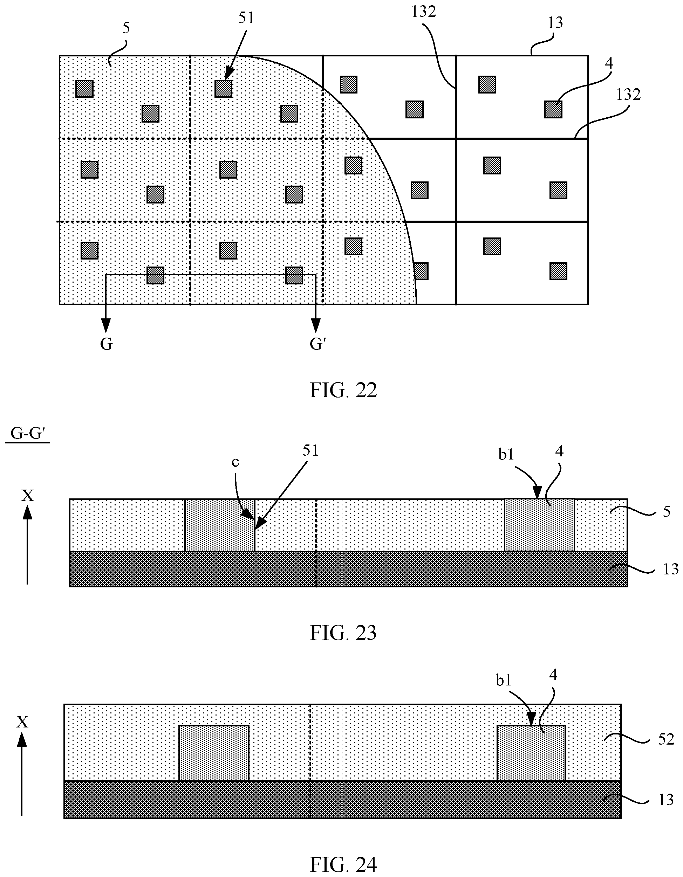

S20: As shown in FIG. 22, form a first plastic packaging layer 5 on the first surface.

As shown in FIG. 23, the first plastic packaging layer 5 forms a first channel 51 at a position corresponding to the first pin 4, the first channel 51 penetrates the first plastic packaging layer 5 in a first direction X, a first conductive surface b1 that is of the first pin 4 and that is away from the mother board is exposed from the first channel 51, and at least a part of the first pin 4 is connected to an inner wall c of the first channel 51.

In some embodiments, the first plastic packaging layer 5 is processed by using a grinding process.

For example, S20 includes the following.

As shown in FIG. 24, a plastic packaging film 52 is formed on the first surface of the mother board 13, where the plastic packaging film 52 wraps each first pin 4.

Here, the plastic packaging film 52 wraps a first conductive surface b1 and a surface intersecting the first conductive surface b1 that are of each pin.

The plastic packaging film 52 is ground, as shown in FIG. 23, to expose the first conductive surface b1.

In some other embodiments, the first plastic packaging layer 5 is formed by using a tape molding (tape molding) process.

For example, S20 includes the following.

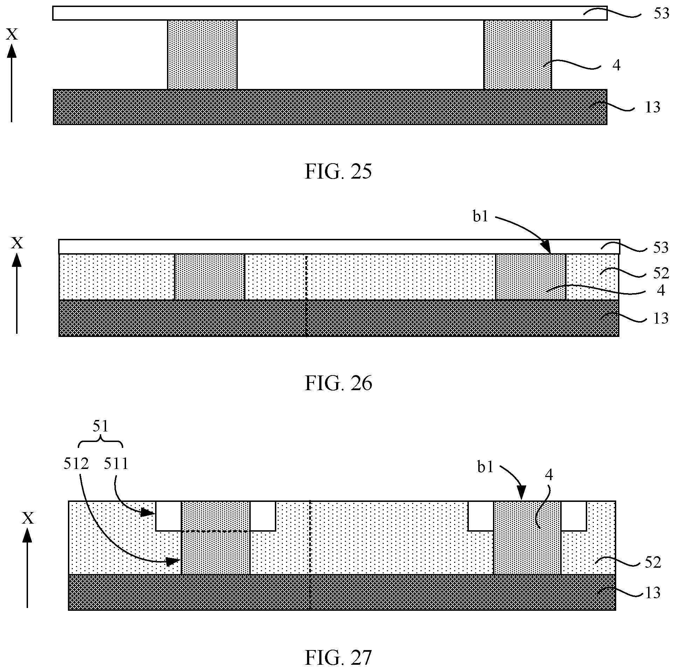

As shown in FIG. 25, a barrier film 53 is attached to the first conductive surface b1 of the first pin 4, where the barrier film 53 is attached to a first conductive surface b1 of each first pin 4.

The barrier film 53 is attached to the first conductive surface b1 of each first pin 4, so that it can be ensured that after the barrier film 53 is removed, the first conductive surface b 1 of each first pin 4 can be exposed, so as to ensure the complete electrical connection.

As shown in FIG. 26, a plastic packaging material is filled between the mother board 13 and the barrier film, where the plastic packaging material wraps a surface that is of each first pin 4 and that intersects the first conductive surface b1 to form a plastic packaging film 52.

The barrier film 53 is removed, as shown in FIG. 23, to expose the first conductive surface b1.

Based on the foregoing description, in some embodiments, after the first conductive surface b1 is exposed, S20 further includes the following.

As shown in FIG. 27, a groove is made between the plastic packaging film 52 and the first pin 4 to form a first subchannel 511 having a gap with the first pin 4 and a second subchannel 512 connected to the first pin 4.

The second subchannel 512 communicates with the first subchannel 511 and the second subchannel 512 is disposed closer to the mother board 13 than the first subchannel 511.

For example, the plastic packaging material around the pin 4 may be removed by using a laser, and a groove is made between the first pin 4 and the first channel 51. A part of the first channel 51 that has a groove with the first pin 4 serves as the first subchannel 511, and a part of the first channel 51 that is connected to the first pin 4 serves as the second subchannel 512.

The manufacturing method for the packaging device further includes: forming a second plastic packaging layer 10.

It may be understood that, when the second pin 11 and the second electronic component 12 are not disposed on the second surface of the mother board 13, as shown in FIG. 18, the second plastic packaging layer 10 is a complete film layer.

When the second pin 11 and the second electronic component 12 are disposed on the second surface of the mother board 13, as shown in FIG. 19, the second plastic packaging layer 10 includes a second channel 101, configured to place the second pin 11 and a part of the second electronic component 12.

When the plurality of cutting paths 132 intersect to define one device area 131, manufacturing of the packaging device 420 is completed. When the plurality of cutting paths 132 intersect to define a plurality of device areas 131, the manufacturing method for the packaging device 420 further includes the following step.

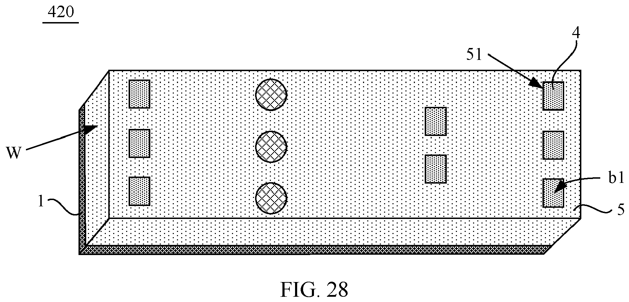

S30: Cut the mother board 13 on which the first plastic packaging layer 5 is formed along the cutting paths 132 to form the packaging device 420 shown in FIG. 28.

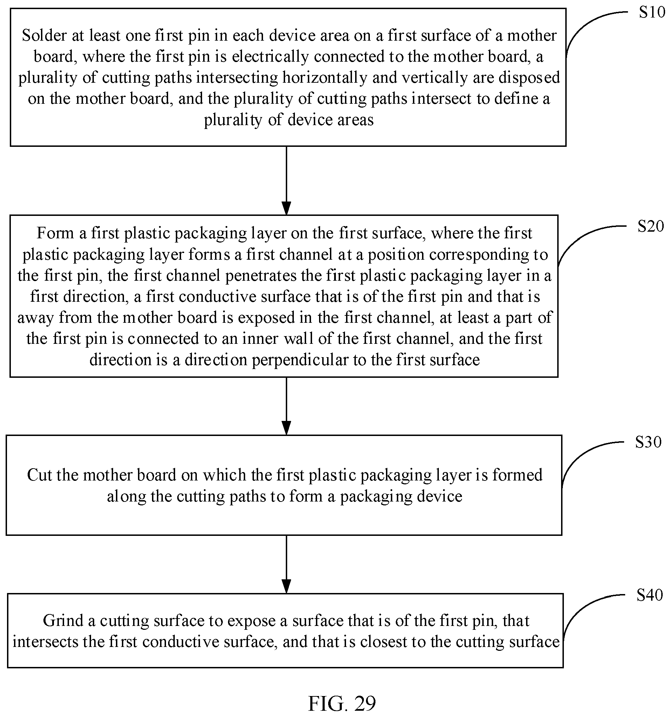

As shown in FIG. 29, in some embodiments, the manufacturing method for the packaging device further includes the following step.

S40: Grind a cutting surface (a W surface in FIG. 28) to expose a surface that is of the first pin 4, that intersects the first conductive surface b1, and that is closest to the cutting surface, to form the packaging device 420 shown in FIG. 2.

It may be understood that, the surface exposed after the grinding is a part of a surface that is of the first pin 4 and that intersects the first conductive surface b1.For example, when the first pin 4 is a quadrangular prism, the surface exposed after the grinding is a surface closest to the cutting surface among surfaces that are of the first pin 4 and that intersect the first conductive surface b1.

The surface exposed after the grinding is used as a second conductive surface b2 of the first pin 4, and the second conductive surface b2 is flush with a side surface that is of the finally formed packaging device and that intersects the first surface a1.

The grinding may be performed on only one cutting surface, or the grinding may be performed on a plurality of cutting surfaces. The cutting surface herein is a side surface, formed by cutting along the cutting paths 132, that is of the packaging device and that intersects the first surface a1.

In addition to having the same beneficial effects as the foregoing packaging device, the manufacturing method for the packaging device provided in this embodiment of this application further has the following features.

In a conventional technology, the first pin 4 is soldered after the circuit board 1 is packaged, and thermal shock to the plastic packaging layer 3 is caused by relatively high heat generated in a soldering process, which leads to separation of the plastic packaging layer 3 and the circuit board 1, or leads to short circuit after remelting of a solder joint between the electronic component 2 and the circuit board 1, affecting performance of the packaging device. However, according to the manufacturing method for the packaging device provided in this application, before the first plastic packaging layer 5 is formed, the first pin 4 and the first electronic component 9 are soldered on the circuit board 1, so no thermal shock is caused to the first plastic packaging layer 5, there is no remelting of the solder joint between the first electronic component 9 and the circuit board 1, and quality of the packaging device can be ensured.

In addition, in this application, the first electronic component 9 and the first pin 4 may be soldered on the circuit board 1 at a same manufacturing stage, without a need to solder the first pin 4 after entering another process following soldering the first electronic component 9, thereby shortening a manufacturing process of the packaging device.

An embodiment of this application further provides an electronic device, where the electronic device includes any one of the foregoing packaging devices 420. The electronic device used in this embodiment of this application may be, for example, a display device or a communication device such as a tablet computer, a mobile phone, an electronic reader, a remote control, a personal computer (personal computer, PC), a notebook computer, a personal digital assistant (personal digital assistant, PDA), an in-vehicle device, a network television, a wearable device, a television, a base station, a relay, or a network device in a wireless network. A specific form of the electronic device is not specifically limited in this embodiment of this application. For ease of description, an example in which the electronic device is a wireless communication device, for example, a mobile phone or a base station, is used in the following for description.

In an example, the electronic device is a mobile phone. In this case, the packaging device 420 may be, for example, a power module, the external device 410 may be, for example, a main board, and the main board may be implemented in a form of a printed circuit board (printed circuit board, PCB).

In another example, the electronic device is a base station. In this case, the packaging device 420 may be, for example, a power module or a radio frequency module, and the external device 410 may be implemented in a form of a PCB.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A packaging device, comprising:
a circuit board having a first surface;
a first plastic packaging layer covering the first surface, wherein the first plastic packaging layer comprises at least one first channel, the first channel penetrates the first plastic packaging layer in a first direction, and the first direction is a direction perpendicular to the first surface; and
at least one first pin, wherein the first pin is electrically connected to the circuit board, one first pin is located in one first channel, at least a part of the first pin is connected to an inner wall of the first channel, a first conductive surface that is of the first pin and that is away from the circuit board is exposed from the first channel, and the first pin is electrically connected to an external device by using the first conductive surface.

2. The packaging device according to claim 1, wherein the first channel comprises a first subchannel and a second subchannel that are connected, and the second subchannel is disposed closer to the circuit board than the first subchannel;
there is a gap between a surface of the first pin facing an inner wall of the first subchannel and the inner wall of the first subchannel; and
a surface of the first pin facing an inner wall of the second subchannel is connected to the inner wall of the second subchannel.

3. The packaging device according to claim 1 or 2, wherein the first channel is a through hole, the first channel is located in an area enclosed by side surfaces of the first plastic packaging layer, and the side surfaces of the first plastic packaging layer intersect the first surface.

4. The packaging device according to claim 1 or 2, wherein the first channel is a through groove disposed on a side surface of the first plastic packaging layer, and the side surface of the first plastic packaging layer intersects the first surface.

5. The packaging device according to claim 4, wherein the first pin has a second conductive surface flush with a side surface of the circuit board that intersects the first surface, the second conductive surface comprises a first conductive subsurface and a second conductive subsurface, and the second conductive subsurface is disposed closer to the circuit board than the first conductive subsurface; and
the packaging device further comprises a solder mask covering the second conductive subsurface.

6. The packaging device according to claim 5, wherein the packaging device further comprises a first conductive protective layer covering the first conductive subsurface.

7. The packaging device according to any one of claims 1 to 6, wherein the packaging device further comprises a second conductive protective layer covering the first conductive surface.

8. The packaging device according to any one of claims 1 to 7, wherein the first conductive surface is flush with an upper surface that is of the first plastic packaging layer and that is away from the circuit board.

9. The packaging device according to any one of claims 1 to 8, wherein the packaging device further comprises a first electronic component;
the first electronic component is disposed on the first surface, and is electrically connected to the circuit board; and
an upper surface that is of the first electronic component and that is away from the circuit board is flush with the upper surface that is of the first plastic packaging layer and that is away from the circuit board, or an upper surface that is of the first electronic component and that is away from the circuit board is covered by the first plastic packaging layer.

10. The packaging device according to any one of claims 1 to 9, wherein the circuit board further has a second surface disposed opposite to the first surface;
the packaging device further comprises a second plastic packaging layer covering the second surface; and
a thickness of the first plastic packaging layer is equal to a thickness of the second plastic packaging layer.

11. A manufacturing method for a packaging device, comprising:
soldering at least one first pin in each device area on a first surface of a mother board, wherein the first pin is electrically connected to the mother board, a plurality of cutting paths intersecting horizontally and vertically are disposed on the mother board, and the plurality of cutting paths intersect to define a plurality of device areas;
forming a first plastic packaging layer on the first surface, wherein a first channel is formed in the first plastic packaging layer at a position corresponding to the first pin, the first channel penetrates the first plastic packaging layer in a first direction, the first direction is a direction perpendicular to the first surface, a first conductive surface that is of the first pin and that is away from the mother board is exposed from the first channel, the first pin is electrically connected to an external device by using the first conductive surface, and at least a part of the first pin is connected to an inner wall of the first channel; and
cutting the mother board on which the first plastic packaging layer is formed along the cutting paths to form the packaging device.

12. The manufacturing method for the packaging device according to claim 11, wherein the forming a first plastic packaging layer on the first surface comprises:
forming a plastic packaging film on the first surface of the mother board, wherein the plastic packaging film wraps each first pin; and
grinding the plastic packaging film to expose the first conductive surface to form the first plastic packaging layer.

13. The manufacturing method for the packaging device according to claim 11, wherein the forming a first plastic packaging layer on the first surface comprises:
attaching a barrier film to the first conductive surface of the first pin, wherein the barrier film is attached to a first conductive surface of each first pin;
filling a plastic packaging material between the mother board and the barrier film, wherein the plastic packaging material wraps a surface that is of each first pin and that intersects the first conductive surface to form a plastic packaging film; and
removing the barrier film to expose the first conductive surface to form the first plastic packaging layer.

14. The manufacturing method for the packaging device according to claim 12 or 13, wherein the forming a first plastic packaging layer on the first surface after exposing the first conductive surface further comprises:
making a groove between the plastic packaging film and the first pin to form a first subchannel having a gap with the first pin and a second subchannel connected to the first pin, wherein the second subchannel communicates with the first subchannel and is disposed closer to the mother board than the first subchannel.

15. The manufacturing method for the packaging device according to any one of claims 11 to 14, wherein after the cutting the mother board on which the first plastic packaging layer is formed, the manufacturing method for the packaging device further comprises:
grinding a cutting surface to expose a surface that is of the first pin, that intersects the first conductive surface, and that is closest to the cutting surface.

16. An electronic device, comprising the packaging device according to any one of claims 1 to 10.
